# EUROPEAN PATENT SPECIFICATION

(11) **EP 0 856 744 B1**
(45) Date of publication and mention of the grant of the patent: **24.09.2003**
(21) Application number: 98105087.5
(22) Date of filing: 29.07.1992
(51) Int. Cl.: G01R 33/422

(54) **NMR probe incorporating RF shielding of sample**
NMR-Sonde mit HF-Abschirmung der Probe
Sonde de RMN incorporant un blindage HF de l'échantillon

(30) Priority: 07.08.1991 US 741721
(43) Date of publication of application: 05.08.1998
(62) Divisional of application: 92916864.9
(73) Proprietor: Varian, Inc., Palo Alto, CA 94304 (US)
(72) Inventor: Hill, Howard D.W., Cupertino, CA 95014 (US); Cummings, Michael D., Sunnyvale, California 94087-1705 (US)
(74) Representative: Foster, Mark Charles

(56) References cited:
- DE-A- 3 621 107
- US-A- 4 871 969
- D.A. ALDERMAN, D.M. GRANT: "An Efficient Decoupler Coil Design ..." JOURNAL OF MAGNETIC RESONANCE, vol. 36, 1979, pages 447-451, XP002064306

## Description

### Field of the Invention

The invention is in the field of nuclear magnetic resonance apparatus and particularly relates to improvements in RF probe structure.

### Background of the Invention

In studies of high resolution NMR phenomena one limiting characteristic is the signal-to-noise ratio. The noise has a diverse origin and includes sources other than simple stochastic contributions. It is known that leads of the RF coil may serve as sources of parasitic radiation which may affect a sample under investigation. The present work is predicated upon improvements to RF probe performance incident to incorporating structure having the effect of eliminating, in the sensitive volume of the apparatus, RF signal pickup originating from coil leads and otherwise shielding the sample from discontinuities of the termination of the coil itself (end effects).

The polarizing field of the NMR apparatus is carefully shimmed to provide for the highest achievable uniformity in the central region of the RF coil where the coil design provides for application of the desired irradiation. The sample is ordinarily of extended dimension along one axis to avoid discontinuity in this sensitive volume, but sample regions removed from the center region of the sensitive volume may experience a significantly different polarizing field and therefore resonate at a different frequency. Steps taken to suppress solvent excitation in the center region of the sensitive volume may be ineffective against spurious excitation from coil leads near the ends of the sample. A broad resonance, shifted from the solvent peak can result, masking relatively weak intensity spectral features in this region.

In prior art, an appreciation of the possibility of parasitic excitation arising from radiation from coil leads was discussed in EP-A-0303095. A structure was there described comprising symmetrical excited coil portions with the null point of the coil assembly furnishing a virtual ground for a shield plate disposed between the coil and that portion of the coil leads proximate the coil.

The effect of parasitic RF irradiation from coil leads is especially important in such situations where solvent suppression is required to observe spectral lines close to solvent resonances. With low sample concentration, e.g., 10⁻³ the solvent line(s) are inherently about 10⁶ times as intense as the lines under study. Measures taken for suppression of a solvent resonance assume that such measures (saturation, for example) are ideally achieved. Where the sample has physical extension in regions beyond the sensitive volume and close to coil leads, even very weak radiation of the solvent (in the end portion) of the sensitive volume is sufficient to produce an undesired signal contribution.

The problem is exacerbated in certain composite probe structures. It is not uncommon for two coils to be coaxially disposed with the sample occupying a capillary along the common axis. One example of such structure is the use of quadrature coils. In another common arrangement an inner coil may be provided for ¹³C irradiation and the outer coil provided for proton irradiation. Even in the case where such a probe is in use exclusively for proton resonance measurements and the inner coil is nominally inert, the presence of the inner coil leads, close to a portion of the sample (even though far from the center of the sensitive volume) provides a means for re-radiating the proton irradiation on the remote sample portion.

Use of a floating guard ring, coaxially disposed inside of a slotted resonator is described in W0-A-92/17799. This structure was understood to provide capacitive couplings between resonator portions separated by slots, or simply to provide a virtual ground in symmetric geometrical and electrical relationship to an outer ring structure.

The article D1: D.A. ALDERMAN, D.M. GRANT: 'An Efficient Decoupler Coil Design ...' JOURNAL OF MAGNETIC RESONANCE, vol. 36, 1979, pages 447-451, discloses a decoupler coil having two guard rings that are kept at RF ground.

US-A-4871969 discloses an RF shield for use between a set of gradient coils and an RF coil of an NMR device. The RF shield is hollow and formed of a single conductor sheet divided into first and second opposed halves, each having a set of conductive streamline portions with a series of nonconductive cut lines formed therebetween. Each of the cut lines is parallel to the RF current and is of a generally oval shape. Each of the shield conductor loops is further separated into a "C"-shaped conductive portion, along at least one radial line, and the C portions are then connected so as to continue shielding the RF current, yet pass gradient magnetic fields in all three mutual orthogonal directions or a Cartesian coordinate system.

US-A-4785246 discloses a magnetic resonance imaging apparatus having an electromagnetic coupling prevention member interposed between a probe head and magnetic field coils. The electromagnetic coupling prevention member is cylindrical and has four slits cut into it. The electromagnetic coupling prevention member is set to ground potential.

The invention provides an RF coil structure as claimed in claim 1.

An embodiment of the invention will now be described by way of example, with reference to the accompanying drawings, in which:
FIG. 1 illustrates the context of the invention.
FIG. 2(a) shows a single turn saddle coil. FIG. 2(b) shows one variation for controlled temperature measurements.
FIG. 3a shows an example spectrum obtained without a closure disc.
FIG 3b shows the same example spectrum obtained with a closure disc.
FIG. 4 illustrates an embodiment of the invention.
FIG. 5a shows spectra obtained with a two channel probe of prior art.
FIG. 5b shows spectra obtained with the two channel prior art probe with the improvement of the present invention.

### Detailed Description of the Present Invention

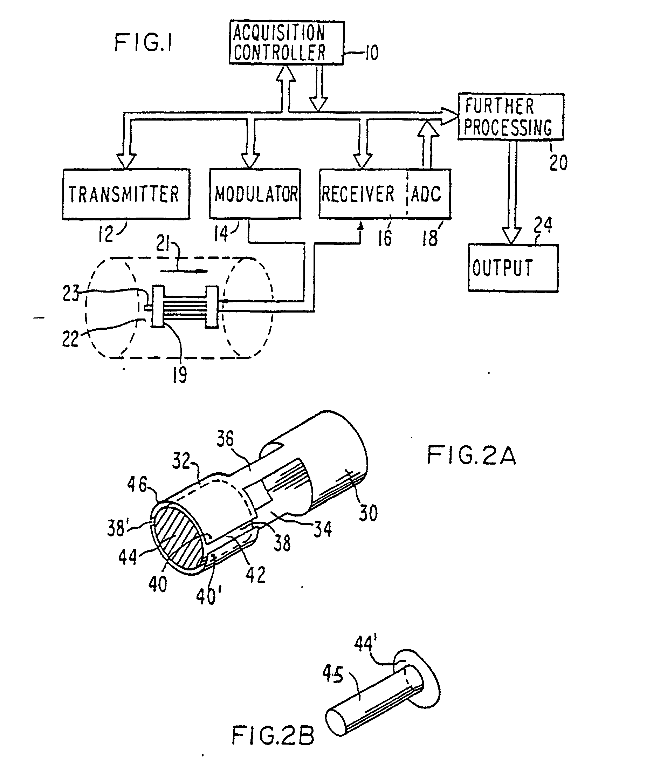

Portions of a typical NMR data acquisition instrument are schematically illustrated in FIG. 1. An acquisition/control processor 10 communicates with an RF transmitter 12, modulator 14 and receiver 16, including analog-to-digital convertor 18 and a further digital processor 20. The modulated RF power irradiates an object 23 in a magnetic field 21 through a probe assembly 22 and response of the object is intercepted by probe 22 communicating with receiver 16. The response typically takes the form of a transient time domain waveform or free induction decay. This transient waveform is sampled at regular intervals and samples are digitized in adc 18. The digitized time domain wave form is then subject to further processing in processor 20. The nature of such processing may include averaging the time domain waveform over a number of similar of such waveforms and transformation of the average time domain wave form to the frequency domain yields a spectral distribution function directed to output device 24. Alternatively this procedure may thus be repeated with variation of some other parameter and the transformation(s) from the data set may take on any of a number of identities for display or further analysis.

The magnetic field 21 which polarizes the sample and defines the Larmor frequency thereof, is established by an appropriate means, not shown. Saddle coil(s) 19 are employed for imposing a desired spacial and time dependence of magnetic field.

Turning now to FIG 2A, there is shown a single turn saddle coil. A particular coil structure comprises a ring 30 and ring 32, the latter segmented by gaps 38 and 38'. Rings 30 and 32 are connected by paraxial conductors 34 and 36. Leads 40 and 40' provide the feed from an RF source, e.g. transmitter 12 modulator 14. To this structure there is added a floating inner ring 42, closed off by closure disk 44 proximate to the leads 40 and 40'. A sample tube disposed on the axis of the coil is therefore shielded from parasitic radiation from leads 40 and 40' and from the edge effects of the end 46 of ring 32 of the coil.

Mechanical support (not shown) for the saddle coil of FIG. 2A may be provided by an insulating cylindrical tube or a plurality of small diameter rods as described in U.S. 4,517,516. The floating ring is preferably supported directly from the interior of ring 32, or independently supported.

In a number of measurements, temperature control of the sample is accomplished by flow of a controlled temperature gas stream about the sample. Complete closure of the floating ring 42 with disk 44 would prevent or reduce passage of the gas stream in the portion of the sample adjacent the floating ring 42. Accordingly, the disk 44 may be provided with perforations or the closure may employ a mesh material. At the price of slight degradation of the RF shielding properties of disk 44, the benefit of temperature control of the entire sample is retained. Alternatively, a chimney 45 may be adapted to provide gas flow through closure disk 44' as in FIG. 2(b). The chimney 45 serves to provide the required shielding of the sample from RF leads. In still another alternative, the axial extension of ring 42 may extend beyond the termination of ring 32 by an amount sufficient to assure acceptable shielding.

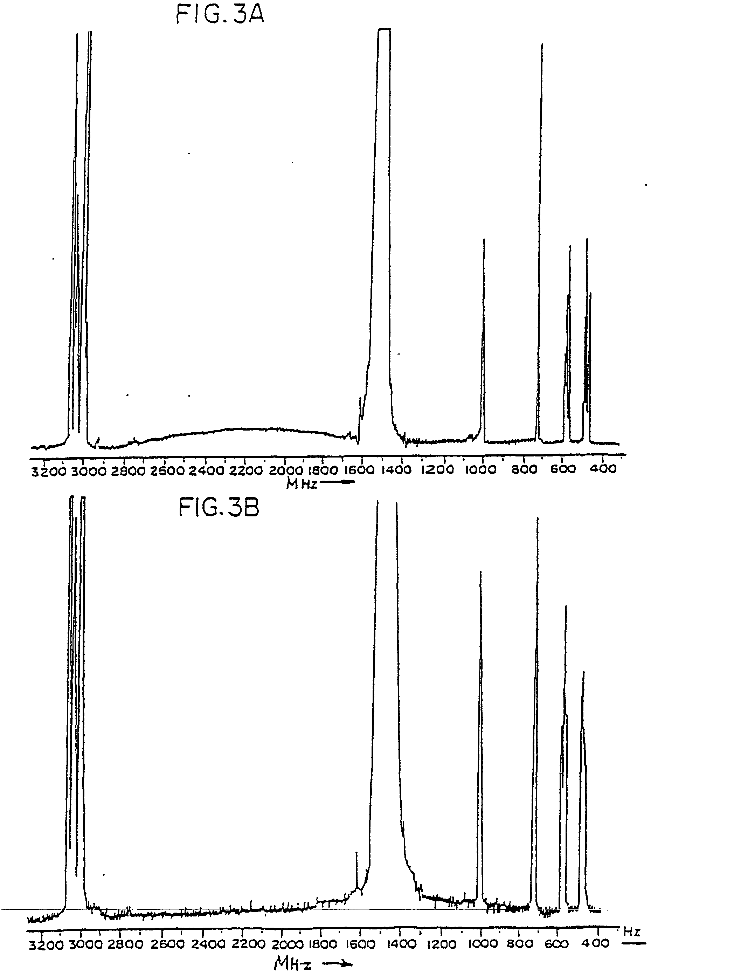

The effect of the closure of the floating ring 42 with disk 44 is illustrated in FIG 3a (without closure disk 44) and FIG. 3b (with closure disk 44) for a sample of phenylalanine in 90% H₂O-10% D₂O. Closure disk 44 contained perforations for temperature control as discussed above. The spectral response of the instrument in the region close to the solvent peak and particularly from 1700 to 2700 MHz is particularly illustrative of the effect of the shielding.

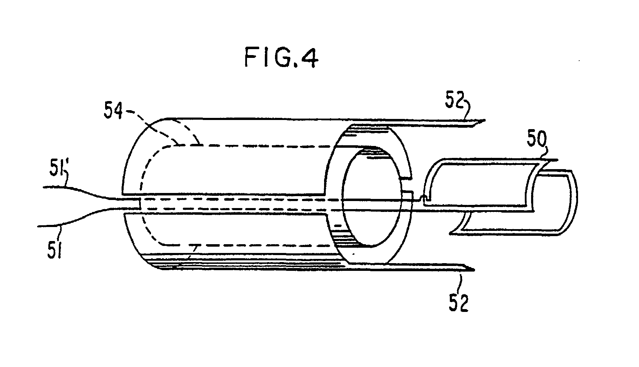

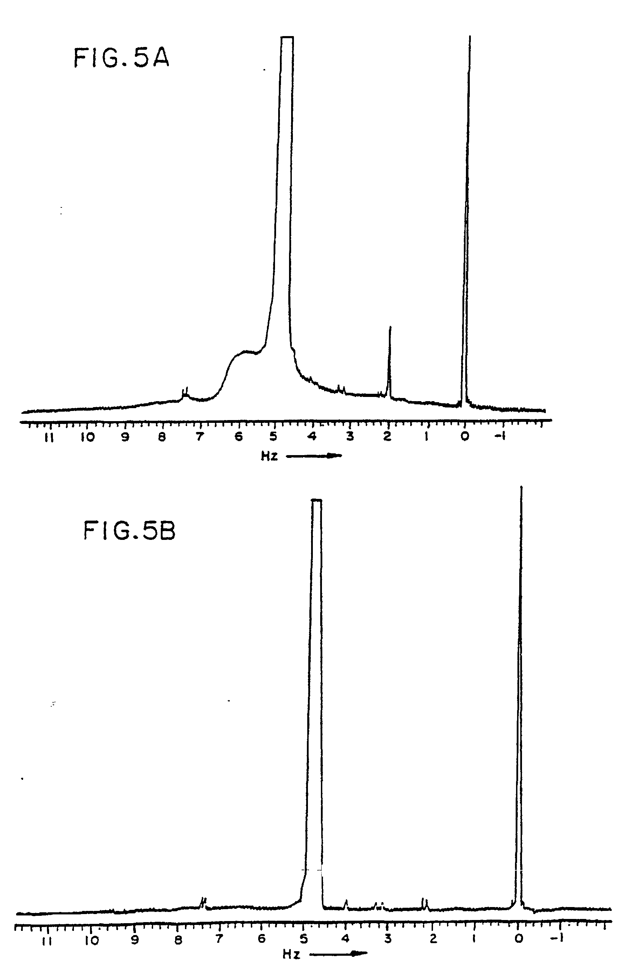

Shielding of the sample from parasitic radiation may occur in other contexts as well. Consider typical composite coil structures comprising quadrature coils or coaxial coils. In one common (coaxial) arrangement shown in FIG. 4 an inner coil 50 is employed for ¹³C excitation and the outer coil 52 for ¹H excitation. The probe may be of a type in which, for example, the inner coil 50 may be completely idle while the outer coil 52 is active. Nevertheless, it has been found that the presence of the inner coil 50 (specifically, its leads) 51-51' provides a medium for re-radiation (of the proton radiation) on portions of the axially disposed sample (not shown) proximate the inner coil leads 51-51'. In an example, a (relatively) long floating shield 54 is mechanically supported directly on the exterior of the inner coil 50. FIG. 5(a) and FIG. 5(b) compare spectra of the identical sample in a dual (coaxial) coil structure without (FIG. 5(a)) and equipped with (FIG. 5(b)) the floating ring.

It is to be understood that many changes can be made in the specifically described embodiments without departing from the scope of the invention and that the invention is to be determined from the scope of the following claims without limitation of the specifically described embodiments.

## Claims

1. An RF coil structure for applying an RF magnetic field to a sample disposed within the RF coil structure, comprising a radially inner coil (50) having lead means (51,51') for connecting the inner coil with an RF source, and a radially outer RF coil (52) mounted coaxially with the inner coil (50), the inner and outer coils (50, 52) arranged for excitation of different sorts of nuclei, further comprising an electrically floating shield (54) disposed around the exterior of the leads of the inner coil (50), the shield (54) being arranged radially between said outer coil (52) and said leads such that, when said inner coil (50) is idle and the outer coil (52) is active, re-radiation of radiation from the outer coil by means of the lead means (51,51') of the inner coil (50) on portions of a sample axially disposed within the inner coil (50) proximate the lead means (51,51') is reduced.

2. An RF coil according to claim 1, wherein the inner coil (50) is for ¹³C excitation, and the outer coil is for ¹H excitation.

## Patentansprüche

1. RF-Spulenstruktur zum Anlegen eines RF-Magnetfeldes an eine Probe, die innerhalb der RF-Spulenstruktur angeordnet ist, mit einer radial inneren Spule (50) mit einem Zuleitungsmittel (51, 51') zum Verbinden der inneren Spule mit einer RF-Quelle, und einer radial äußeren RF-Spule (52), die koaxial mit der inneren Spule (50) montiert ist, wobei die innere und die äußere Spule (50, 52) zur Anregung von verschiedenen Arten von Atomkernen angeordnet sind, ferner mit einer elektrisch schwebenden Abschirmung (54), die um das Äußere der Zuleitungen der inneren Spule (50) angeordnet ist, wobei die Abschirmung (54) radial zwischen der äußeren Spule (52) und den Zuleitungen derart angeordnet ist, daß, wenn die innere Spule (50) im Ruhezustand ist und die äußere Spule (52) aktiv ist, eine Rückstrahlung der Strahlung von der äußeren Spule mittels des Zuleitungsmittels (51, 51') der inneren Spule (50) auf Teile einer Probe, die axial innerhalb der inneren Spule (50) angeordnet ist, nahe dem Zuleitungsmittel (51, 51') verringert wird.

2. RF-Spule nach Anspruch 1, wobei die innere Spule (50) zur ¹³C-Anregung dient und die äußere Spule zur ¹H-Anregung dient.

## Revendications

1. Structure à bobines de radiofréquences pour appliquer un champ magnétique dans les radiofréquences à un échantillon disposé à l'intérieur de la structure à bobine de radiofréquence, comprenant une bobine interne radiale (50) qui comprend des moyens formant conducteur de sortie (51, 51') pour connecter la bobine interne (50) à une source de radiofréquence, et une bobine de radiofréquence externe radiale (52) montée de façon coaxiale avec la bobine interne (50), la bobine interne et la bobine externe (50, 52) étant agencée pour l'excitation de différentes sortes de noyaux, comprenant en outre un blindage flottant (54) disposé autour de la partie extérieure des conducteurs de sortie de la bobine interne (50), le blindage (54) étant agencé de façon radiale entre ladite bobine externe (52) et lesdits conducteurs tel que, lorsque ladite bobine interne (50) est inactive et la bobine externe (52) est active, le rerayonnement du rayonnement en provenance de la bobine externe au moyen des moyens formant conducteurs de sortie (51, 51') de la bobine interne (50) sur les parties de l'échantillon disposé de façon axiale à l'intérieur de la bobine interne (50) proches des moyens formant conducteurs de sortie (51, 51') est réduit.

2. Bobine de radiofréquence selon la revendication 1, dans laquelle la bobine interne (50) est pour l'excitation de ¹³C et la bobine externe est pour l'excitation de ¹H.
